# EUROPÄISCHE PATENTSCHRIFT

(11) **EP 3 346 546 B1**
(45) Veröffentlichungstag und Bekanntmachung des Hinweises auf die Patenterteilung: **16.12.2020**
(21) Anmeldenummer: 18150228.7
(22) Anmeldetag: 03.01.2018
(51) Int. Cl.: H01Q 1/22, H01Q 1/44, H01Q 9/42, H01Q 19/10

(54) **ANTENNENVORRICHTUNG MIT BONDDRÄHTEN**
ANTENNA DEVICE WITH BOND WIRES
DISPOSITIF D'ANTENNE POURVU DE FIL DE CONNEXION

(30) Priorität: 05.01.2017 DE 102017200132
(43) Veröffentlichungstag der Anmeldung: 11.07.2018
(60) Teilanmeldung: 19152556.7
(73) Patentinhaber: Fraunhofer-Gesellschaft zur Förderung der angewandten Forschung e.V., 80686 München (DE)
(72) Erfinder: NDIP, Ivan, 13469 Berlin (DE)
(74) Vertreter: Hersina, Günter

(56) Entgegenhaltungen:
- WO-A1-00/21030
- WO-A1-00/65691
- WO-A1-2014/049088
- WO-A1-2014/088210
- WO-A2-2011/025241
- US-A1- 2006 028 378
- US-A1- 2007 170 560
- US-A1- 2014 138 446

## Beschreibung

Die Erfindung betrifft eine Antennenvorrichtung mit den Merkmalen von Anspruch 1.

In der Halbleiter- bzw. Mikrosystemtechnik werden zum Verbinden und elektrischen Kontaktieren von integrierten Schaltkreisen mit anderen elektrischen Strukturen dünne Drähte benutzt. Das hierbei eingesetzte Verfahren wird auch als Drahtbonden bezeichnet und die verwendeten dünnen Drähte werden dementsprechend auch als Bonddrähte bezeichnet. Diese Bonddrähte dienen also in erster Linie dazu, eine galvanische Verbindung zwischen zwei elektrisch leitfähigen Strukturen zu schaffen.

Beispielsweise können integrierte Schaltkreise (IC) mittels Bonddrähten mit Strukturen an einem den IC tragenden Substrat galvanisch verbunden werden. Bezüglich integrierter Schaltkreise sind zum Beispiel Hochfrequenz-Mikrochips bekannt, die Antennenports zum Anschließen von Antennen aufweisen. Die Antennenports bilden Anschlussbereiche für Antennen und gleichzeitig Signalausgänge mittels derer ein zu übertragendes Signal an die daran angeschlossene Antenne übertragen werden kann.

Hierbei ist es bekannt Bonddrähte als Strahler bzw. Antennen zu nutzen. So bildet beispielsweise ein Bonddraht, der einen Antennenport eines Mikrochips mit einer elektrisch abschließenden Struktur auf einem den Mikrochip tragenden Trägersubstrat verbindet, eine Antenne. Diese Form von Antennen wird auch als Bonddrahtantenne bezeichnet.

Eine solche Bonddrahtantenne ist beispielsweise in der US 2008/0291107 A1 beschrieben. Hier wird ein HF-Chip mittels Bonddrähten mit einem Bondpad auf dem Substrat verbunden. Der HF-Chip weist einen differentiellen Antennenanschluss, d.h. zwei Antennenports, auf, wobei an jedem Antennenport jeweils ein Bonddraht angeschlossen ist. Es wird außerdem beschrieben, dass die beiden Bondpads auf dem Substrat mit einem elektrisch leitfähigen Pfad verbunden werden können, um eine gefaltete Dipolstruktur zu realisieren. Aufgrund der beiden differentiellen Antennenports liegt bei der in dieser Druckschrift beschriebenen Antennenstruktur der den Abschluss der Antenne bildende Bereich immer auf dem Chip.

Die US 7,768,456 B2 zeigt eine ähnliche Struktur. Hier werden ebenfalls zwei Bonddrähte, die an zwei differentiellen Antennenports des Chips angeschlossen sind, auf an dem Substrat angeordnete Bondpads geführt. Die beiden Bondpads sind ebenfalls mittels eines elektrischen Leiters miteinander verbunden. Diese Druckschrift beschreibt, dass für diese Verbindung eine metallische Platte zu verwenden sei. Um einen möglichst direkten bzw. linearen Stromfluss zwischen den beiden Bondpads zu gewährleisten sollte die Breite der metallischen Platte stets größer sein als der Durchmesser der Bonddrähte.

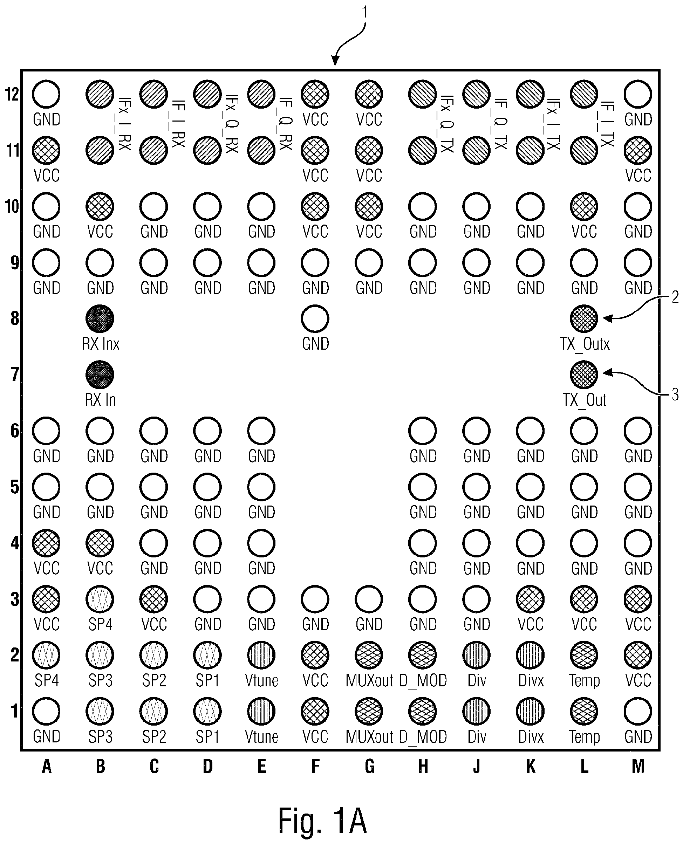

Bekannte HF-Chips weisen in der Regel lediglich zwei (differentielle) Antennenports auf, sodass höchstens zwei Bonddrähte als Antenne genutzt werden können. Figur 1A zeigt eine solche Pinbelegung eines bekannten Chips 1. Der Chip 1 weist einen ersten Antennenport 2 und einen zweiten Antennenport 3 auf.

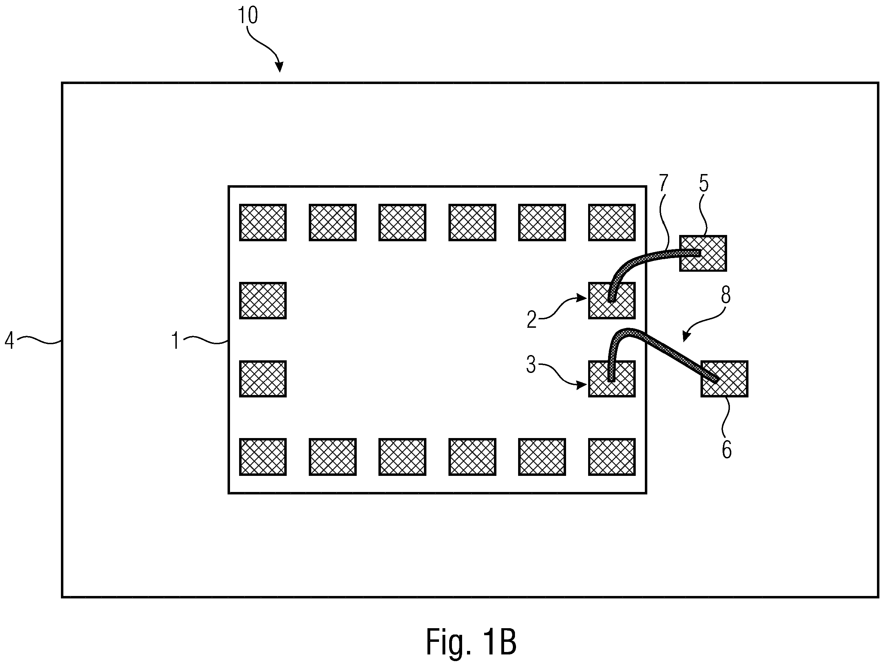

Figur 1B zeigt ein weiteres Beispiel aus dem Stand der Technik. Hier ist ein zuvor erwähnter Chip 1 auf einem Substrat 4 angeordnet. Das Substrat 4 weist ein erstes Bondpad 5 und ein zweites Bondpad 6 auf. Ein erster Bonddraht 7 verbindet den ersten Antennenport 2 des Chips 1 mit dem ersten Bondpad 5. Ein zweiter Bonddraht 8 verbindet den zweiten Antennenport 3 des Chips 1 mit dem zweiten Bondpad 6.

Die US 2006 / 028 378 A1 beschreibt einen derartigen auf einem Substrat angeordneten Hochfrequenzchip, wobei eine Vielzahl an Bonddrähten jeweils von unterschiedlichen Antennenports an der Chipoberfläche zu einer Substratoberfläche geführt sind. Außerdem können Bonddrähte nur auf der Chipoberseite angeordnet sein.

Weitere bekannte Antennenstrukturen sind beispielsweise in den Druckschriften WO 00/21030 A1, WO 00/65691 A1, WO 2014/ 088210 A1, US 2014/ 136 446 A1 sowie US 2007 / 170 560 A1 beschrieben.

Die oben genannten bekannten Bonddrahtantennen haben den Vorteil, dass die zum galvanischen Verbinden verwendeten Bonddrähte gleichzeitig als Strahler bzw. Antenne genutzt werden können. Somit kann auf separate Antennenstrukturen verzichtet werden.

Es ist jedoch schwierig, die Antennen abzustimmen. Dies gilt insbesondere für Funksignale im Hochfrequenzbereich mit einer Wellenlänge im Millimeterbereich. Hier führen bereits Schwankungen der Antennenlänge im Bereich von wenigen Millimetern oder Mikrometern zu großen Abweichungen im Strahlungsverhalten der Antenne.

Prinzipiell bestimmt sich die Wellenlänge des mit der Bonddrahtantenne auszusenden Funksignals unter anderem durch die Länge der Antenne, d.h. durch die Länge des Bonddrahts, der zwischen dem HF-Chip und dem Bondpad auf dem Substrat gespannt ist. In der Regel sind die Bondpads auf dem Substrat an definierten Stellen des Substrats positioniert. Auch die Antennenports am HF-Chip sind an definierten Stellen des Chips positioniert. Die Abstände zwischen den Antennenports auf dem Chip und den Bondpads auf dem Substrat sind somit also vorgegeben und können darüber hinaus, in Abhängigkeit des Chipherstellers bzw. Substratherstellers, deutlich variieren. Hinzu kommt, dass auch beim Chipbonden des HF-Chips auf das Substrat Abweichungen in der relativen Positionierung zueinander auftreten können, d.h. die hergestellten Chip-Substrat-Anordnungen sind in der Regel nicht hundertprozentig identisch zueinander.

Das heißt, die Anpassung der Länge des Bonddrahts unterliegt gewissen Restriktionen, die sich unter anderem aus den vorgenannten Positionen der Bondpads relativ zu den Antennenports ergibt. Zum Beispiel muss der Bonddraht zwangsläufig eine gewisse Mindestlänge aufweisen, um den Antennenport überhaupt mit dem Bondpad auf dem Substrat verbinden zu können. Diese mechanisch vorgegebene Mindestlänge des Bonddrahts muss dabei jedoch nicht mit der zur Abstimmung der Bonddrahtantenne gewünschten Länge des Bonddrahts übereinstimmen. Die Länge des Bonddrahts kann also nicht einfach auf die gewünschte Wellenlänge des Funksignals abgestimmt werden ohne hierbei die vorgegebenen (z.B. mechanischen) Restriktionen (z.B. Mindestlänge) zu beachten.

Andererseits kann ein Bonddraht auch nicht beliebig lang sein. Aufgrund seines sehr dünnen Durchmessers neigt ein Bonddraht mit zunehmender Länge immer dazu abzubrechen.

Dies macht es in der Praxis schwierig, die bekannten Bonddrahtantennen genau auf die gewünschte Wellenlänge des auszusenden Funksignals abzustimmen. Eigentlich müsste hierfür für jede Substrat-Chip-Anordnung ein individueller Bonddraht konfiguriert werden. Dies würde jedoch zu unprofitablen Kosten bei der Herstellung führen. Aus diesem Grund weisen die heutzutage bekannten maschinell gefertigten Bonddrahtantennen teilweise große Schwankungen in der Strahlungscharakteristik, z.B. hinsichtlich ihres Antennengewinns auf.

Es ist daher eine Aufgabe der vorliegenden Erfindung, bekannte Bonddrahtantennen unter Berücksichtigung der oben genannten Probleme zu verbessern.

Die Antennenvorrichtung gemäß Anspruch 1 weist ein Substrat auf, auf dem die zuvor genannte Reihenschaltung der beiden Bonddrähte einschließlich der drei Befestigungsbereiche angeordnet ist. Die erfindungsgemäße Antennenvorrichtung kann also auch ohne HF-Chip herstellbar sein und separat mit einem HF-Chip verbindbar sein. Das Substrat weist eine erste Hauptseite und eine gegenüberliegend angeordnete zweite Hauptseite sowie einen ersten, einen zweiten und einen dritten an der ersten Hauptseite angeordneten Befestigungsbereich zum Befestigen von elektrischen Leitern auf. Der erste Befestigungsbereich ist bei der Antennenvorrichtung gemäß Anspruch 1 auf dem Substrat angeordnet. Der erste Befestigungsbereich kann hierbei zur Signalversorgung für den ersten und zweiten Bonddraht dienen. Um eine Rückführung der eingespeisten Leistung zu gewährleisten weist das Substrat gemäß Anspruch 1 eine an der zweiten Hauptseite angeordnete Metallisierung auf. Ferner sind der auf der ersten Hauptseite des Substrats angeordnete dritte Befestigungsbereich und die an der zweiten Hauptseite des Substrats angeordnete Metallisierung mittels einer elektrisch leitfähigen Struktur, die sich durch das Substrat hindurch erstreckt, verbunden. Somit kann der den HF-Chip und das Substrat verbindende erste Bonddraht geeignet gewählt werden, um die zuvor erwähnten vorgegebenen Restriktionen zu erfüllen. Gleichzeitig kann die Länge des zweiten Bonddrahts hingegen geeignet gewählt werden, um die Antenne abzustimmen. Dies macht es im Vergleich zum Stand der Technik wesentlich einfacher, die geometrische Länge der Antenne auf einen bestimmten Wellenlängenbereich abzustimmen, denn die Länge des zweiten Bonddrahts kann im Vergleich zum ersten Bonddraht wesentlich freier gewählt werden. Außerdem kann mit der vorliegenden Erfindung die Gefahr des Drahtbruchs verhindert werden, da nicht ein einzelner langer Bonddraht sondern zwei einzelne Bonddrähte verwendet werden können, um in Summe die jeweils selbe Länge zu erreichen. Außerdem kann die erfindungsgemäße Antennenvorrichtung vorteilhaft dazu genutzt werden, um auf einfache Art und Weise verschiedenste Antennenkonfigurationen zu realisieren.

Weitere vorteilhafte Ausführungsformen der Erfindung sind in den abhängigen Ansprüchen definiert.

Ausführungsbeispiele der Erfindung sind in der Zeichnung dargestellt und werden nachstehend erläutert. Es zeigen:
- Fig. 1A: eine Draufsicht auf die Pinbelegung eines bekannten Chips aus dem Stand der Technik,
- Fig. 1: B eine Draufsicht auf ein Substrat mit einem Chip und zwei den Chip mit dem Substrat verbindenden Bonddrähten nach dem Stand der Technik,
- Fig. 2A: eine Draufsicht auf eine Antennenvorrichtung gemäß einem Beispiel,
- Fig. 2B: eine Draufsicht auf eine weitere Antennenvorrichtung gemäß einem Beispiel,
- Fig. 3: eine Seitenansicht der Antennenvorrichtung aus Figur 2A,
- Fig. 4: eine Seitenansicht einer Antennenvorrichtung gemäß einem Beispiel,
- Fig. 5: eine Seitenansicht einer Antennenvorrichtung gemäß einem Beispiel,
- Fig. 6A: eine Draufsicht auf die Antennenvorrichtung aus Figur 5,
- Fig. 6B: eine Draufsicht auf ein Antennenarray, das eine Mehrzahl von Antennenvorrichtungen gemäß Fig. 6A umfasst,
- Fig. 6C: eine Draufsicht auf ein weiteres Antennenarray, das eine Mehrzahl von Antennenvorrichtungen gemäß Fig. 6A umfasst,
- Fig. 7: eine Seitenansicht einer erfindungsgemäßen Antennenvorrichtung gemäß einem Ausführungsbeispiel,
- Fig. 8A: eine schematische Ansicht eines ersten und eines zweiten Bonddrahts, die an einem gemeinsamen Befestigungsbereich befestigt sind,
- Fig. 8B: eine weitere schematische Ansicht eines ersten und eines zweiten Bonddrahts, die an einem gemeinsamen Befestigungsbereich befestigt sind,
- Fig. 9: eine Draufsicht auf eine Antennenvorrichtung gemäß einem Beispiel,
- Fig. 10: eine Seitenansicht der Antennenvorrichtung aus Figur 9,
- Fig. 11: eine Draufsicht auf ein erfindungsgemäßes Antennenarray gemäß einem Ausführungsbeispiel,
- Fig. 12A: eine Draufsicht auf ein weiteres erfindungsgemäßes Antennenarray gemäß einem Ausführungsbeispiel,
- Fig. 12B: eine Draufsicht auf ein weiteres erfindungsgemäßes Antennenarray gemäß einem Ausführungsbeispiel, das als Yagi-Uda-Antenne ausgeführt ist,
- Fig. 13A: eine schematische Seitenschnittansicht einer Antennenvorrichtung, die ein Gehäuse umfasst, und
- Fig. 13B: eine schematische Seitenschnittansicht einer Antennenvorrichtung, bei der das Gehäuse eine Linse bildet.

Im Folgenden werden bevorzugte Ausführungsbeispiele der Erfindung mit Bezug auf die Figuren näher beschrieben, wobei Elemente mit derselben oder ähnlichen Funktion mit denselben Bezugszeichen versehen sind. Außerdem werden im Folgenden zunächst die Merkmale der Erfindung mit Bezug auf die Figuren strukturell beschrieben. Im Anschluss daran wird die Funktion der Erfindung beschrieben.

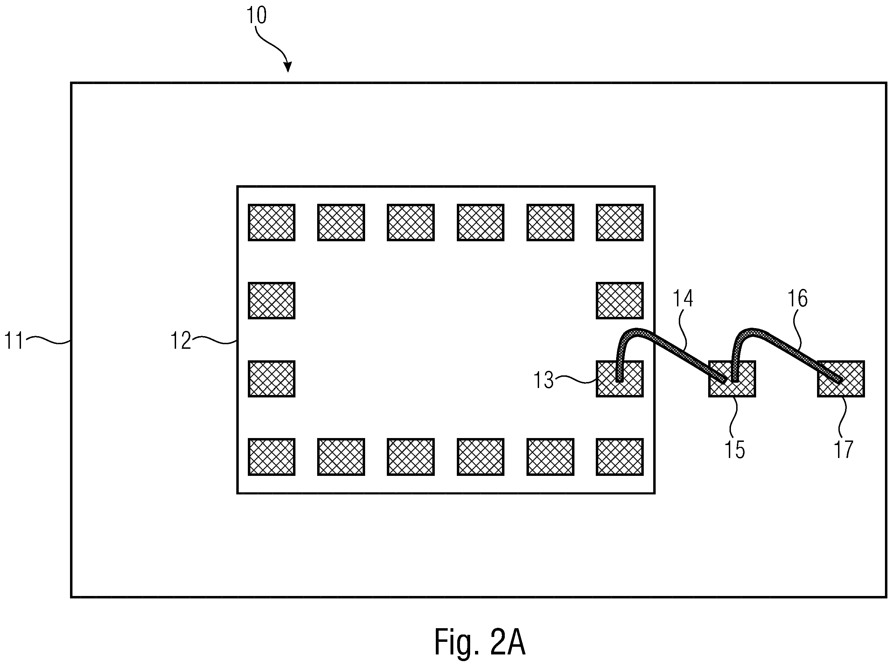

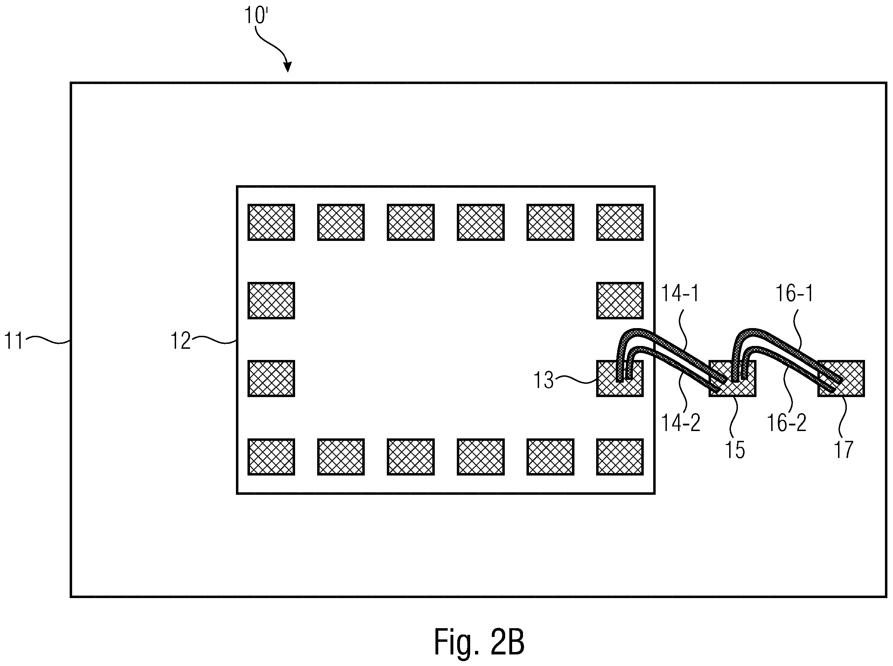

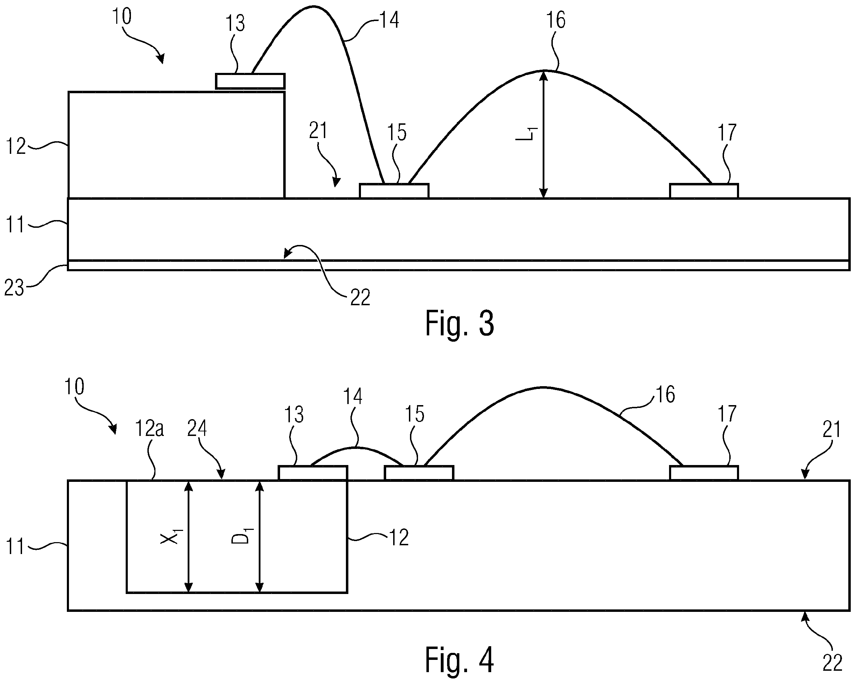

Die Figuren 2A, 2B und 3 zeigen eine beispielhafte Antennenvorrichtung 10. Die Antennenvorrichtung 10 weist unter anderem einen auf einem Substrat 11 angeordneten Hochfrequenz-Chip 12 auf, wobei der Hochfrequenz-Chip 12 mindestens einen Antennenausgangsanschluss 13 aufweist. Der Antennenausgangsanschluss 13 dient als ein erster Befestigungsbereich für einen elektrischen Leiter.

Die Antennenvorrichtung 10 weist außerdem einen ersten Bonddraht 14 auf, der den Antennenausgangsanschluss 13 mit einem auf dem Substrat 11 angeordneten zweiten Befestigungsbereich 15 elektrisch leitend verbindet.

Die Antennenvorrichtung 10 weist ferner einen zweiten Bonddraht 16 auf, der den zweiten Befestigungsbereich 15 und einen auf dem Substrat 11 angeordneten dritten Befestigungsbereich 17 elektrisch leitend verbindet.

Erfindungsgemäß bilden die beiden elektrisch in Reihe geschalteten ersten und zweiten Bonddrähte 14, 16 eine Antenne, insbesondere eine Bonddrahtantenne.

Außerdem sind der erste und der zweite Bonddraht 14, 16 zumindest bereichsweise von dem Substrat 11 beabstandet. So ist beispielsweise in Figur 3 gezeigt, dass der zweite Bonddraht 16 in vertikaler Richtung von dem Substrat 11 beabstandet ist, und zwar um ein Maß L₁ an einer Stelle maximaler Beabstandung.

An den ersten Befestigungsbereich 13, den zweiten Befestigungsbereich 15 oder den dritten Befestigungsbereich 17 kann ein elektrisches Signal anlegbar sein. Bei dem elektrischen Signal kann es sich beispielsweise um ein Hochfrequenzsignal handeln. Als hochfrequent wird im Zusammenhang mit hierin beschriebenen Ausführungsbeispielen insbesondere ein Signal verstanden, das eine Frequenz von zumindest 150 kHz aufweist. Das elektrische Signal weist bevorzugt eine Frequenz von zumindest 1 MHz auf und ist besonders bevorzugt zur Erzeugung von sogenannten Mikrowellen, Millimeter-Wellen oder Terahertz nutzbar, die etwa eine Frequenz in einem Frequenzband von zumindest 30 GHz bis höchstens 300 GHz aufweisen. Andere Frequenzbereiche sind ebenfalls realisierbar. Als Millimeter-Wellen werden Wellenlängen in einem Bereich von zumindest 1 mm und höchstens 10 mm verstanden, die über den Zusammenhang λ = c/f mit einer Frequenz des elektrischen Signals korrespondieren.

Gemäß einer denkbaren Ausgestaltung ist der Hochfrequenz-Chip 12 auf einer ersten Hauptseite 21 des Substrats 11 angeordnet, und auf einer der ersten Hauptseite 21 gegenüberliegenden zweiten Hauptseite 22 des Substrats 11 ist eine Metallisierung 23 an dem Substrat 11 angeordnet, wie beispielhaft in Figur 3 gezeigt.

Gemäß einer weiteren denkbaren Ausgestaltung, wie sie beispielhaft in Figur 4 dargestellt ist, weist das Substrat 11 auf der ersten Hauptseite 21 eine sich in Richtung der zweiten Hauptseite 22 erstreckende Aussparung 24 auf. Der Hochfrequenz-Chip 12 ist in dieser Aussparung 24 angeordnet.

Gemäß einer Ausgestaltung entspricht die Tiefe X₁ der Aussparung 24 dabei der Dicke D₁ des Hochfrequenz-Chips 12, sodass die Oberseite 12a des Hochfrequenz-Chips 12 komplanar zu der ersten Hauptseite 21 des Substrats 11 ist, wenn der Hochfrequenz-Chip 12 in der Aussparung 24 angeordnet ist. Hierdurch kann die Distanz zwischen dem ersten Befestigungsbereich 13 auf dem Chip 12 und dem zweiten Befestigungsbereich 15 auf dem Substrat 11 verkürzt werden, sodass die Länge des ersten Bonddrahts 14 entsprechend verkürzt werden kann, im Vergleich zu einer Ausgestaltung wie sie z.B. in Figur 3 gezeigt ist.

Wie es anhand der Figur 2B für die Antennenvorrichtung 10 detailliert dargestellt ist, sind in manchen Ausführungsformen zwei oder mehr Bonddrähte 14-1 und 14-2 oder 16-1 und 16-2 parallel zwischen zwei Befestigungsbereiche 13 und 15 bzw. 15 und 17 geschaltet, was eine hohe Performanz oder Abstrahleffizienz der Antennenvorrichtung 10' ermöglicht.

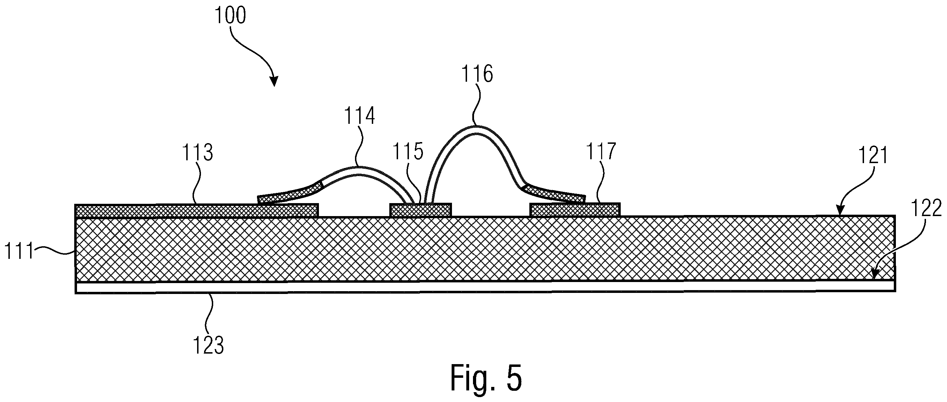

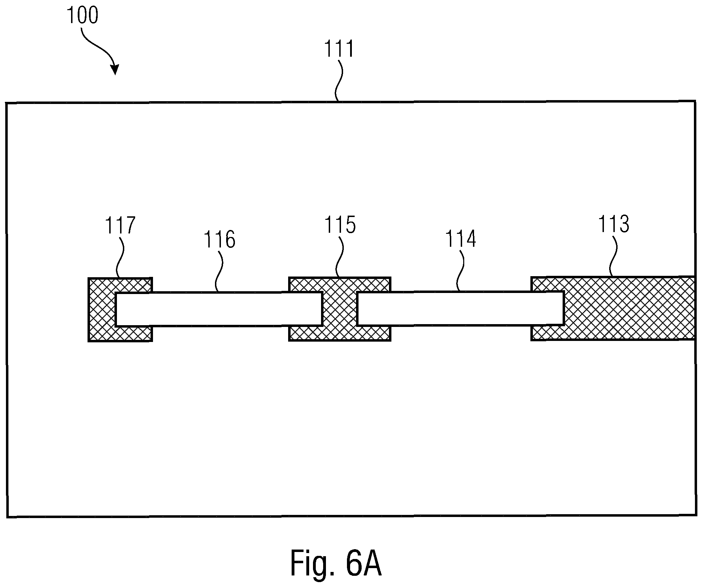

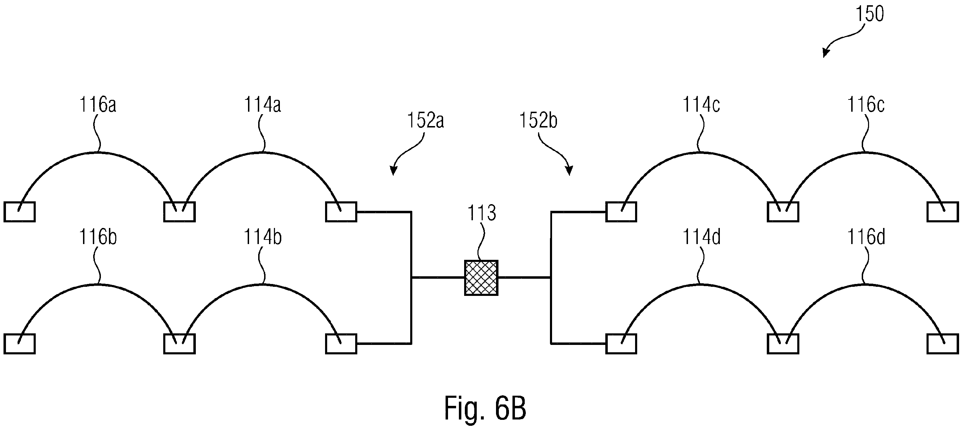

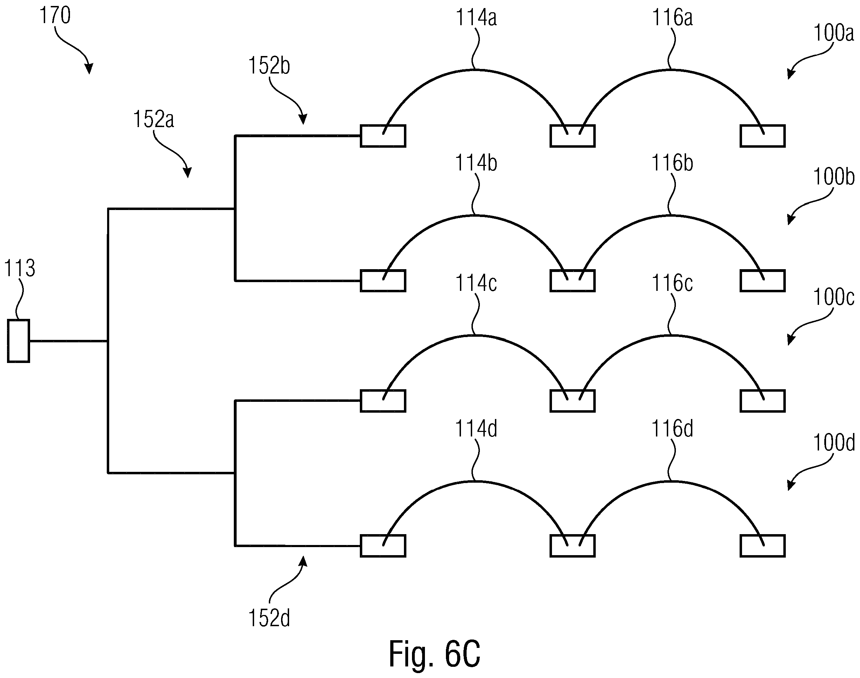

Die Figuren 5 und 6A zeigen eine weitere beispielhafte Antennenvorrichtung 100, während die Figuren 6B und 6C beispielhafte Antennenarrays 150 und 170 zeigen, die hiervon abgeleitet werden können. Die Antennenvorrichtung 100 weist unter anderem ein Substrat 111 auf, das eine erste Hauptseite 121 und eine gegenüberliegend angeordnete zweite Hauptseite 122 aufweist.

Die Antennenvorrichtung 100 weist außerdem einen ersten, einen zweiten und einen dritten an der ersten Hauptseite 121 des Substrats 111 angeordneten Befestigungsbereich 113, 115, 117 zum Befestigen von elektrischen Leitern auf.

Die Antennenvorrichtung 100 weist ferner einen den ersten Befestigungsbereich 113 und den zweiten Befestigungsbereich 115 verbindenden ersten Bonddraht 114, der zumindest bereichsweise von dem Substrat 111 beabstandet ist, auf.

Weiterhin weist die Antennenvorrichtung 100 einen den zweiten Befestigungsbereich 115 und den dritten Befestigungsbereich 117 verbindenden zweiten Bonddraht 116, der zumindest bereichsweise von dem Substrat 111 beabstandet ist, auf.

Die erfindungsgemäße Antennenvorrichtung 100 weist zudem eine an der zweiten Hauptseite 122 des Substrats 111 angeordnete Metallisierung 123 auf, die gegenüberliegend von zumindest einem des ersten Befestigungsbereichs 113, des zweiten Befestigungsbereichs 115, des dritten Befestigungsbereichs 117, des ersten Bonddrahts 114 und des zweiten Bonddrahts 116 angeordnet ist.

Die Metallisierung 123 kann sich über die gesamte Fläche der zweiten Hauptseite 122 des Substrats 111 erstrecken. Selbiges gilt im Übrigen auch für die zuvor mit Bezug auf die Figuren 2A, 2B, 3 und 4 diskutierten Ausgestaltungen.

Wie es in den Figuren 6B und 6C zu sehen ist, kann eine Mehrzahl oder Vielzahl von Antennenvorrichtungen 100a, 100b, 100c und 100d über ein Netzwerk von Spannungs- oder Leistungsteilern 152a und 152b und 152c mit einer Versorgungsleitung oder dem HF-Chip verbunden sein. Beispielsweise kann jeweils ein Schenkel eines ersten Leistungsteilers 152a mit einem weiteren Leistungsteiler 152b bzw. 152c oder mit einer Antennenvorrichtung verbunden sein. Ein jeweiliger weiterer Schenkel kann mit weiteren Leistungsteilern oder mit einer der Antennenvorrichtung 10a-10d verbunden sein, so dass insgesamt eine Anzahl von 2^{N} Antennenvorrichtungen versorgbar ist, wobei N einer Anzahl der Stufen des Netzwerks von Leistungsteilern entspricht.

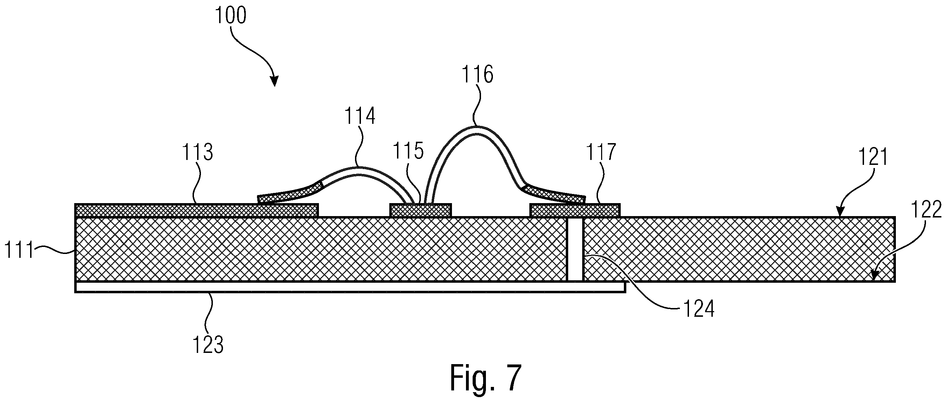

Wie in Figur 7 zu sehen ist, muss sich die Metallisierung 123 nicht über die gesamte Fläche der zweiten Hauptseite 122 des Substrats 111 erstrecken, d.h. die Metallisierung 123 kann erfindungsgemäß auch Unterbrechungen aufweisen.

In dem in Figur 7 gezeigten Beispiel erstreckt sich die Metallisierung 123 lediglich gegenüberliegend von dem ersten, dem zweiten und dem dritten Befestigungsbereich 113, 115, 117 sowie gegenüberliegend von dem ersten und zweiten Bonddraht 114, 116. Andere Teile der zweiten Hauptseite 122 des Substrats 111 bleiben von der Metallisierung 123 unbedeckt. Selbiges gilt im Übrigen auch für die zuvor mit Bezug auf die Figuren 2A, 2B, 3 und 4 diskutierten Beispiele.

Die Antennenvorrichtungen 10, 100 zeichnen sich unter anderem dadurch aus, dass die jeweilige Antennenvorrichtung 10, 100 ausgebildet ist, um, ansprechend auf ein an dem ersten Befestigungsbereich 13, 113 anliegendes elektrisches Signal, ein Funksignal mittels des ersten Bonddrahts 14, 114 und des zweiten Bonddrahts 16, 116 auszusenden, wobei ein Wellenlängenbereich des Funksignals von einer Summe der Länge des ersten Bonddrahts 14, 114, der Länge des zweiten Bonddrahts 16, 116 und einem Abstand a₁₂ zwischen dem ersten Bonddraht 14, 114 und dem zweiten Bonddraht 16, 116 auf dem zweiten Befestigungsbereich 15, 115 beeinflusst ist.

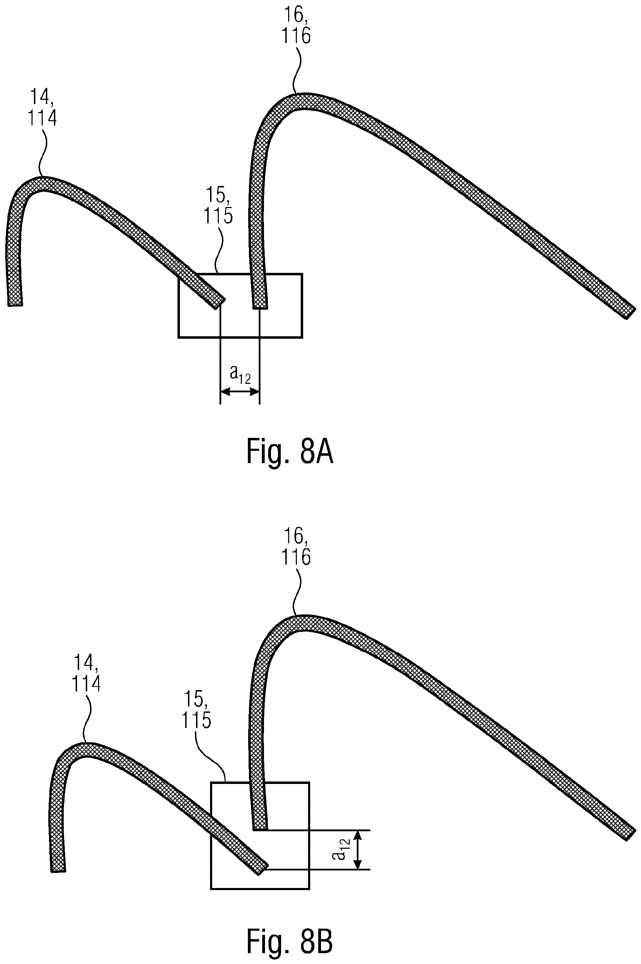

Dieser Umstand ist in den Figuren 8A und 8B gezeigt. Hier sind ausschnittsweise der erste Bonddraht 14, 114, der zweite Bonddraht 16, 116 sowie der zweite Befestigungsbereich 15, 115 abgebildet. Der zweite Befestigungsbereich 15, 115 ist elektrisch leitend. Somit bilden die gemeinsam an dem zweiten Befestigungsabschnitt 15, 115 befestigten Bonddrähte 14, 114; 16, 116 eine elektrische Reihenschaltung.

Wie eingangs erwähnt, bildet diese Reihenschaltung gleichzeitig eine Bonddrahtantenne mittels derer ein Funksignal gesendet oder empfangen werden kann, wobei die Wellenlänge des Funksignals von der Gesamtlänge des ersten Bonddrahts 14, 114, des zweiten Bonddrahts 16, 116 und dem Abstand a₁₂ der beiden Bonddrähte 14, 114; 16, 116 zueinander auf dem zweiten Befestigungsbereich 15, 115 beeinflusst wird.

Erfindungsgemäß werden dabei die Längen des ersten Bonddrahts 14, 114, des zweiten Bonddrahts 16, 116 und der Abstand a₁₂ zwischen dem ersten Bonddraht 14, 114 und dem zweiten Bonddraht 16, 116 auf dem zweiten Befestigungsbereich 15, 115 derart gewählt, dass der Wellenlängenbereich des auszusenden Funksignals im Mikrowellen- oder Millimeterbereich aufweist, etwa eine Frequenz in einem Frequenzband von zumindest 30 GHz bis höchstens 300 GHz aufweisend, bevorzugt zwischen 30 GHz und 80 GHz, oder weiter bevorzugt zwischen 60 GHz und 80 GHz. Andere Frequenzbereiche, z. B. Terahertzbereiche sind ebenfalls realisierbar. Als Millimeter-Wellen werden Wellenlängen in einem Bereich von zumindest 1 mm und höchstens 10 mm verstanden, die über den Zusammenhang λ = c/f mit einer Frequenz des elektrischen Signals korrespondieren.

Eine Auslegung der Länge L der Bonddrahtantenne 14, 114; 16, 116; a₁₂ kann beispielsweise in einem Zusammenhang von L = λ/8, λ/4, λ/2, λ, 2λ, 4λ oder dergleichen erfolgen, wobei λ eine Wellenlänge des Funksignals ist. Bevorzugt ist die Antennenvorrichtung 10 als λ/2-Strahler oder als λ/4-Strahler ausgeführt. Bezüglich des Zusammenhangs zwischen der Wellenlänge λ und der Gesamtlänge L_{ges} kann jeweils ein Toleranzbereich von höchstens 70 %, höchstens 50 % oder höchstens 30 % anwendbar sein. Insbesondere im Millimeter-Wellenlängenbereich kann jedoch eine exakte Auslegung der Länge L der Bonddrahtantenne an ein von der Antennenvorrichtung 10, 100 bereitzustellendes Frequenzband des Funksignals vorteilhaft sein, so dass ein Toleranzbereich von höchstens 30 %, höchstens 20 % oder höchstens 10 % anwendbar sein kann.

Generell kann bei der Antennenvorrichtung 10, 100 die Länge des ersten Bonddrahts 14, 114 kürzer sein als die Länge des zweiten Bonddrahts 16, 116. Somit kann beispielsweise der HF-Chip 12 (Figuren 2A, 2B, 3 und 4) mit einem möglichst kurzen ersten Bonddraht 14, 114 mit dem Substrat 11, 111 verbunden werden, während mittels einer Variation der Länge des zweiten Bonddrahts 16, 116 auf einfache Art und Weise die sich ergebende Bonddrahtantenne 14, 114; 16, 116 abgestimmt werden kann.

Wie in den Figuren 5, 6A und 7 beispielhaft gezeigt ist, kann der erste Befestigungsbereich 113 als eine Streifenleitung ausgeführt sein, wobei ein Wellenlängenbereich eines mittels des ersten Bonddrahts 114, des zweiten Bonddrahts 116 und der Streifenleitung 113 ausgesendeten Funksignals von einer Summe der einzelnen Längen des ersten Bonddrahts 114 und des zweiten Bonddrahts 116 und der Streifenleitung 113 beeinflusst ist. Wie zuvor erwähnt kann auch hier zusätzlich der Abstand a₁₂ der beiden Bonddrähte 114, 116 zueinander auf dem zweiten Befestigungsbereich 115 die Wellenlänge des Funksignals zusätzlich mit beeinflussen. Die Streifenleitung 113 kann zur Signalversorgung des ersten Bonddrahts 114, des zweiten Bonddrahts 116 und des die beiden Bonddrähte 114, 116 verbindenden zweiten Befestigungsbereich 115 dienen.

In einigen Ausführungsbeispielen der Erfindung sind der zweite Befestigungsbereich 15, 115 und der dritte Befestigungsbereich 17, 117 auf dem Substrat 11, 111 angeordnete Bondpads, die räumlich voneinander beabstandet und galvanisch voneinander getrennt sind.

Nachfolgend soll noch einmal unter Bezugnahme auf die Figuren 3, 5 und 7 die Metallisierung 23, 123 erläutert werden. Prinzipiell I, jedoch nicht im Rahmen dieser Erfindung, kann die auf der zweiten Hauptseite
22, 122 des Substrats 11, 111 angeordnete Metallisierung 23, 123 gegenüber den auf der ersten Hauptseite 21, 121 des Substrats 11, 111 angeordneten Strukturen (d.h. erster Befestigungsbereich 13, 113, zweiter Befestigungsbereich 15, 115, dritter Befestigungsbereich 17, 117, erster Bonddraht 14, 114, zweiter Bonddraht 16, 116) galvanisch getrennt sein. Das heißt, es besteht keine elektrisch leitende direkte Verbindung zwischen der Metallisierung 23, 123 und den auf der ersten Hauptseite 21, 121 angeordneten Strukturen.

Gemäß der Erfindung ist der auf der ersten Hauptseite 21, 121 des Substrats 11, 111 angeordnete dritte Befestigungsbereich 17, 117 und die an der zweiten Hauptseite 22, 122 des Substrats 11, 111 angeordnete Metallisierung 23, 123 mittels einer elektrisch leitfähigen Struktur 124, die sich durch das Substrat 11, 111 hindurch erstreckt, verbunden. Bei dieser elektrisch leitfähigen Struktur 124 kann es sich beispielsweise um, auch als Vias bezeichnete, Durchkontaktierungen handeln.

Diese Durchkontaktierungen 124 können alternativ oder zusätzlich auch die Metallisierung 23, 123 und den ersten Befestigungsbereich 13, 113 und/oder den zweiten Befestigungsbereich 15, 115 elektrisch leitend verbinden.

Als vorteilhaft hat es sich herausgestellt, wenn die Durchkontaktierungen 124 die Metallisierung 23, 123 mit dem die Bonddrahtantenne abschließenden Befestigungsbereich galvanisch verbindet. Dies ist in der Regel der dritte Befestigungsbereich 17, 117.

Bei diesen Ausführungsformen mit elektrisch leitenden Durchkontaktierungen 124 wird ein Wellenlängenbereich eines ausgesendeten Funksignals durch die Summe der einzelnen Längen des ersten und des zweiten Bonddrahts 14, 114; 16, 116 und der sich durch das Substrat 11, 111 hindurch erstreckenden elektrisch leitfähigen Struktur 124 beeinflusst. Unabhängig davon, ob die Antennenstruktur 10, 100 eine Durchkontaktierung 124 aufweist oder nicht, kann die an der zweiten Hauptseite 22, 122 des Substrats 11, 111 angeordnete Metallisierung 23, 123 ein Reflektor für ein mittels des ersten Bonddrahts 14, 114 und des zweiten Bonddrahts 16, 116 ausgesendetes Funksignal sein. Hierdurch kann eine gute Schirmung der zweiten Hauptseite 22, 122 des Substrats 11, 111 erreicht werden.

Alternativ zu einer flächigen und als Reflektor ausgeführten Metallisierung 23, 123 ist es ebenfalls möglich, die Metallisierung 23, 123 unterbrochen über die zweite Hauptseite 22, 122 des Substrats 11, 111 hinweg auszuführen. So können unterbrechende Strukturen, etwa Aussparungen, genutzt werden, um Antennenstrukturen zu implementieren. So kann etwa eine schlitzförmige Aussparung in der Metallisierung 23, 123 genutzt werden, um eine Schlitzantenne zu bilden, so dass das Funksignal auch in einer Richtung des Substrats 11, 111 abstrahlt, die den Bonddrähten 14, 114; 16, 116 abgewandt angeordnet ist.

In anderen Worten kann der erste Befestigungsbereich 113 hier als coplanare Speiseleitung bezeichnet werden. Die Metallisierung 23, 123 kann als Reflektor oder Referenzpotential (engl.: Ground Plane) genutzt werden. Der dritte Befestigungsbereich 117 kann als Rückleitung des Speisestroms, der durch die beiden Bonddrähte 114, 116 fließt, genutzt werden.

Durch die zumindest bereichsweise Beabstandung der beiden Bonddrähte 114, 116 von dem Substrat 111 kann eine dreidimensionale Abstrahlung des Funksignals erhalten werden.

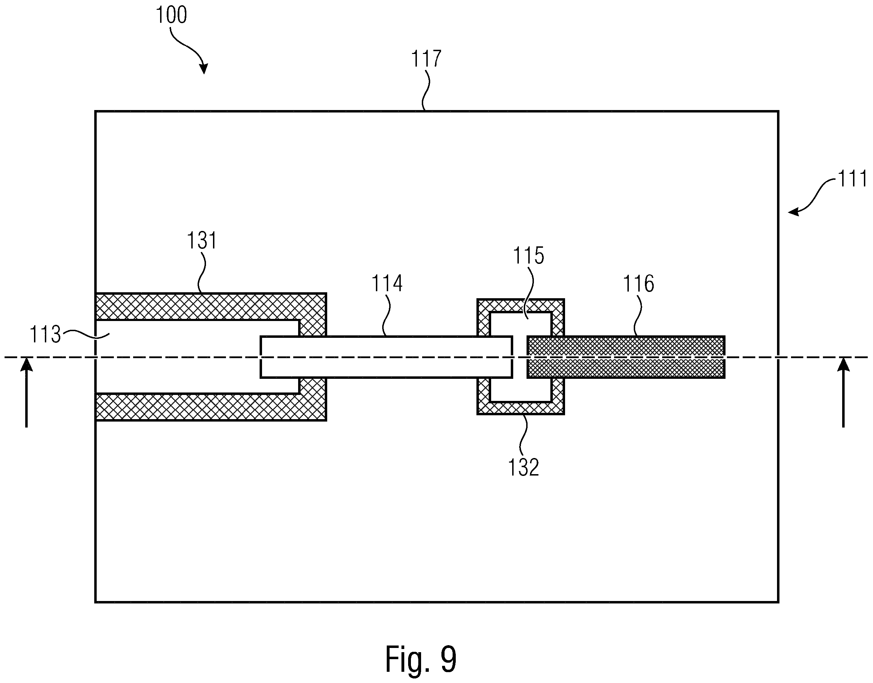

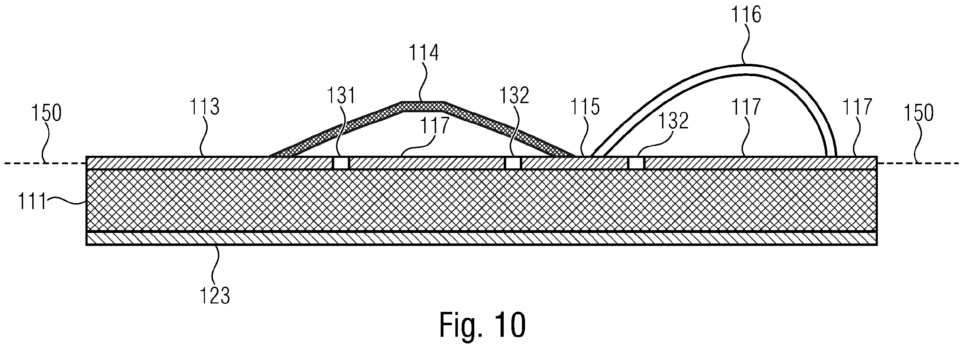

Die Figuren 9 und 10 zeigen ein weiteres Beispiel einer Antennenvorrichtung 100. Hier liegen der erste, der zweite und der dritte Befestigungsbereich 113, 115, 117 alle in derselben Substratebene 150. Außerdem umgibt der dritte Befestigungsbereich 117 in dieser Ebene 150 den ersten Befestigungsbereich 113 und/oder den zweiten Befestigungsbereich 115 zumindest abschnittsweise, sodass der erste Befestigungsbereich 113 bezüglich des zweiten Befestigungsbereichs 115 und/oder bezüglich des dritten Befestigungsbereichs 117 eine komplanare Versorgungs- bzw. Speiseleitung ausbildet. Dies ermöglicht ein geringes Ausmaß an parasitären Abstrahlungen, eine gute Störabstrahleigenschaft und ein hohes Maß an elektromagnetischer Verträglichkeit (EMV).

Hier deckt der dritte Befestigungsbereich 117 sozusagen einen Großteil der Oberfläche ersten Hauptseite 121 des Substrats 111 ab. Der dritte Befestigungsbereich 117 umgibt dabei den ersten Befestigungsbereich 113 und den zweiten Befestigungsbereich 115 zumindest abschnittsweise. Dabei sind die einzelnen Befestigungsbereiche 113, 115, 117 galvanisch voneinander getrennt.

Zwischen dem ersten Befestigungsbereich 113 und dem dritten Befestigungsbereich 117 ist eine erste galvanische Trennstruktur 131 vorgesehen. Zwischen dem zweiten Befestigungsbereich 115 und dem dritten Befestigungsbereich 117 ist eine zweite galvanische Trennstruktur 132 vorgesehen. Die Trennstrukturen 131, 132 können beispielsweise in Form von Durchbrechungen in dem dritten Befestigungsbereich 117 ausgebildet sein. Ebenso wäre es denkbar, dass unter Anwendung von Ätzverfahren entsprechende Gräben 131, 132 in den dritten Befestigungsbereich 117 geätzt werden.

Die Befestigungsbereiche 113, 115, 117 bestehen aus leitfähigem Material. Die Befestigungsbereiche 113, 115, 117 können beispielsweise ein oder mehrere Metalle aufweisen. Zusätzlich kann eine Metallisierung 123 auf der zweiten Hauptseite 122 des Substrats 111 angeordnet sein.

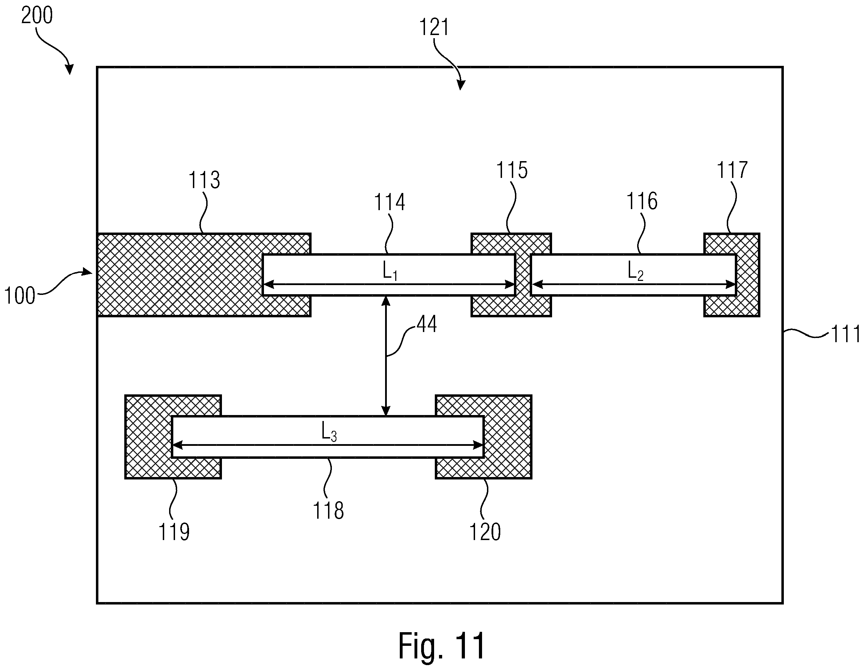

Figur 11 zeigt ein weiteres Beispiel. Bei diesem Beispiel handelt es sich um ein Antennenarray 200, das zusammen mit der zuvor beschriebenen Antennenstruktur 100 aufgebaut werden kann. Das Antennenarray 200 kann entweder mit der zuvor mit Bezug auf die Figuren 2A, 2B, 3 und 4 diskutierten Antennenvorrichtung 10, oder mit der zuvor mit Bezug auf die Figuren 5 bis 10 diskutierten Antennenvorrichtung 100 aufgebaut werden.

Das Antennenarray 200 weist neben zumindest einer Antennenvorrichtung 10, 100 zumindest einen dritten elektrischen Leiter 118 auf. Der dritte elektrische Leiter 118 kann ein Leiterband, eine in dem Substrat 111 integrierte Leiterbahn oder ein Bonddraht sein.

In dem in Figur 11 abgebildeten Beispiel handelt es sich bei dem dritten elektrischen Leiter um einen dritten Bonddraht 118. Dieser dritte Bonddraht 118 verbindet einen auf der ersten Hauptseite 121 des Substrats 111 angeordneten vierten Befestigungsbereich 119 und fünften Befestigungsbereich 120 mechanisch und galvanisch miteinander.

Der vierte Befestigungsbereich 119 und der fünfte Befestigungsbereich 120 sind jeweils galvanisch von den ersten, zweiten und dritten Befestigungsbereichen 113, 115, 117 getrennt, d.h. es besteht keine direkte elektrisch leitende Verbindung zwischen den vierten und fünften Befestigungsbereichen 119, 120 zu einem der ersten, zweiten und dritten Befestigungsbereiche 113, 115, 117.

In anderen Worten ist also die Antennenvorrichtung 10, 100 räumlich und galvanisch von dem vierten Befestigungsbereich 119, dem fünften Befestigungsbereich 120 und dem dritten Bonddraht 118 getrennt. Die Antennenvorrichtung 10, 100 kann jedoch elektromagnetisch mit zumindest dem dritten Bonddraht 118 gekoppelt sein.

Hierbei können die Antennenvorrichtung 10, 100 und der dritte Bonddraht 118 so zueinander angeordnet sein, dass der dritte Bonddraht 118 bezüglich der Antennenvorrichtung 10, 100 als ein Reflektor oder als ein Direktor wirkt.

In anderen Worten kann also das Antennenarray 200 eine der beiden Antennenvorrichtungen 10, 100 mit zumindest einem ersten und zweiten Bonddraht 14, 114; 16, 116, sowie den drei Befestigungsbereichen 13, 113; 15, 115; 17, 117, und zusätzlich mindestens einen dritten Bonddraht 118, der einen vierten und fünften Befestigungsbereich 119, 120 galvanisch miteinander verbindet, aufweisen. Der vierte und fünfte Befestigungsbereich 119, 120 und der dritte Bonddraht 118 sind elektrisch oder galvanisch von den beiden Bonddrähten 14, 114; 16, 116 der Antennenvorrichtung 10, 100 des Antennenarrays 200 getrennt. Der dritte Bonddraht 118 kann eine Länge L₃ aufweisen, die von der Länge L₁ des ersten Bonddrahts 114 und/oder der Länge L₂ des zweiten Bonddrahts 116 und/oder von einer Summe der Längen L₁, L₂ und der Ausdehnung a₁₂ des zweiten Befestigungsbereichs 15, 115 verschieden ist. Ferner kann der dritte Bonddraht 118 mit einem Abstand 44 und in etwa parallel zu dem ersten und/oder dem zweiten Bonddraht 114, 116 angeordnet sein. Dies ermöglicht eine Wirkung des dritten Bonddrahts 118 als Direktor oder Reflektor, wie es beispielsweise von sogenannten Yagi-Uda-Konfigurationen bekannt ist, die ein Driver-Element zur Erzeugung des Funksignals sowie zumindest ein Reflektorelement und zumindest ein Direktorelement umfassen. Das bedeutet, der dritte Bonddraht 118 kann als Reflektor-Antenne oder als Direktor-Antenne wirken, indem es mit zumindest einem der Bonddraht in Wechselwirkung tritt. Alternativ hierzu kann der dritte Bonddraht 118 auch in einer anderen Konfiguration als passiver Strahler angeordnet sein, wobei der Abstand 44, die Länge L₃ und/oder eine Orientierung des dritten Bonddrahts 118 bezüglich des ersten und/oder zweiten Bonddrahts 114, 116 variierbar sind.

Somit können mit einer hierin beschriebenen Antennenvorrichtung 10, 100 nahezu beliebige Antennenarrays 200 bereitgestellt werden. Beispielsweise können mit der hierin beschriebenen Antennenvorrichtung 10, 100 in Kombination mit zumindest einem, wie zuvor beschriebenen, weiteren elektrischen Leiter 118 diverse Antennenarray-Strukturen bereitgestellt werden.

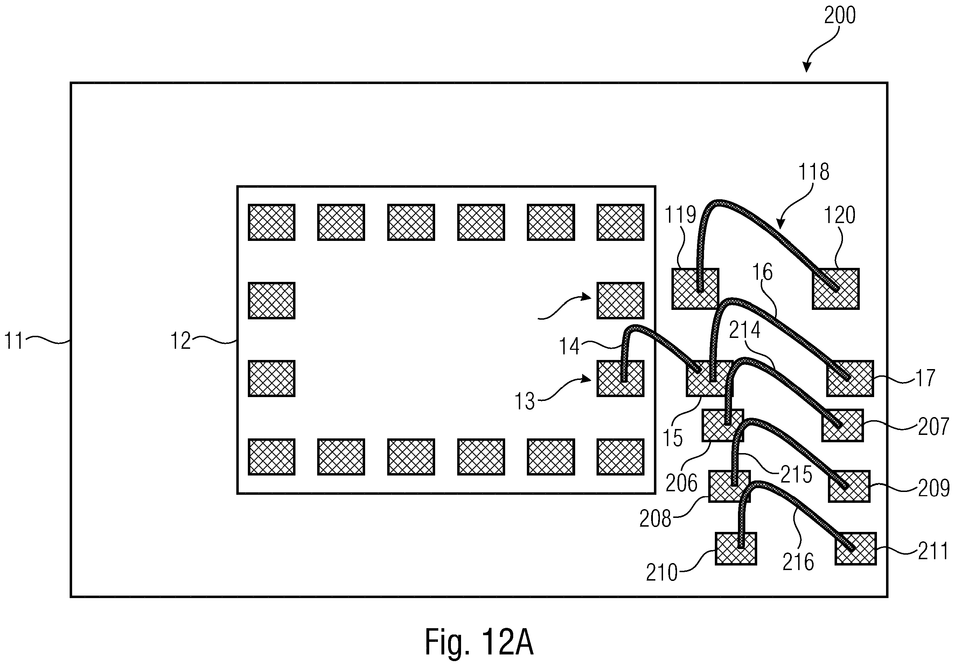

So zeigt beispielsweise Figur 12A ein Antennenarray 200 mit einer Antennenvorrichtung 10, die einen auf einem Substrat 11 angeordneten HF-Chip 12 und mehrere Bonddrähte aufweist. Dieses Antennenarray 200 bildet eine Yagi-Uda-Antenne mittels mehrerer Bonddrähte.

Der HF-Chip 12 weist einen ersten Antennenport 13 auf, der gleichzeitig als ein erster Befestigungsbereich 13 für den ersten Bonddraht 14 dient. Der Bonddraht 14 erstreckt sich von dem ersten Befestigungsbereich 13 zu einem auf dem Substrat 11 angeordneten zweiten Befestigungsbereich 15.

Ein zweiter Bonddraht 16 verbindet den zweiten Befestigungsbereich 15 mit einem auf dem Substrat 11 angeordneten dritten Befestigungsbereich 17. Somit ergibt sich eine Reihenschaltung der ersten und zweiten Bonddrähte 14, 16, die zusammen als Linearstrahler bzw. Monopolantenne agieren.

Auf dem Substrat 11 ist ferner ein dritter Bonddraht 118 angeordnet, der einen vierten und einen fünften Befestigungsbereich 119, 120 miteinander verbindet. Der dritte Bonddraht 118 wirkt hier als ein Reflektor für das mittels der ersten und zweiten Bonddrähte 14, 16 ausgesendeten Funksignals.

Auf dem Substrat 11 ist ferner mindestens ein vierter Bonddraht 214 angeordnet, der einen auf dem Substrat 11 angeordneten sechsten Befestigungsbereich 206 und einen auf dem Substrat 11 angeordneten siebten Befestigungsbereich 207 miteinander verbindet.

Der vierte Bonddraht 214 wirkt hier als ein Direktor für das mittels der ersten und zweiten Bonddrähte 14, 16 ausgesendeten Funksignals.

Auf dem Substrat 11 ist ferner ein fünfter Bonddraht 215 angeordnet, der einen auf dem Substrat 11 angeordneten achten Befestigungsbereich 208 und einen auf dem Substrat 11 angeordneten neunten Befestigungsbereich 209 miteinander verbindet.

Der fünfte Bonddraht 215 wirkt hier als ein weiterer Direktor für das mittels der ersten und zweiten Bonddrähte 14, 16 ausgesendeten Funksignals.

Auf dem Substrat 11 ist ferner ein sechster Bonddraht 216 angeordnet, der einen auf dem Substrat 11 angeordneten zehnten Befestigungsbereich 210 und einen auf dem Substrat 11 angeordneten elften Befestigungsbereich 211 miteinander verbindet.

Der sechste Bonddraht 216 wirkt ebenfalls als ein weiterer Direktor für das mittels der ersten und zweiten Bonddrähte 14, 16 ausgesendeten Funksignals.

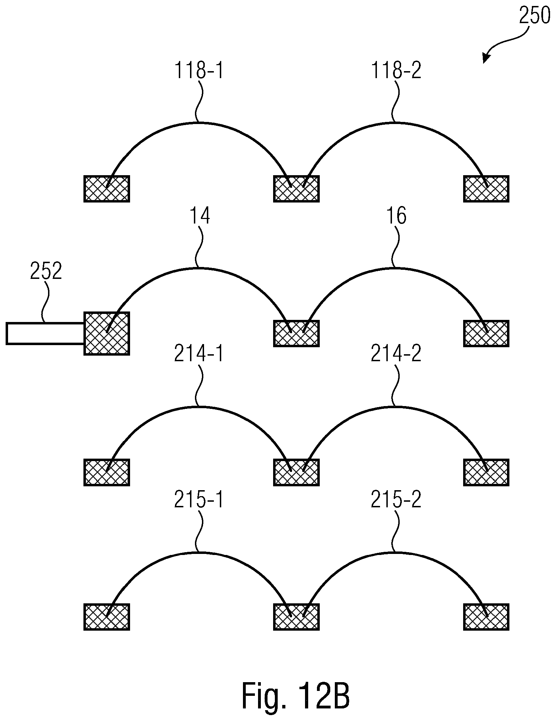

Wie es anhand der Figur 12B für eine Antennenvorrichtung 250 gezeigt ist, kann jeder der Bonddrähte 118, 214, 215 und/oder 216 als Serienschaltung von zumindest zwei Bonddrähten realisiert sein. So kann eine Serienschaltung von Bonddrähten 118-1 und 118-2 als Reflektorelement einsetzbar sein. Eine Serienschaltung von Bonddrähten 214-1 und 214-2 und/oder eine Serienschaltung von Bonddrähten 215-1 und 215-2 kann als Direktorelement einsetzbar sein. Das Driverelement umfassend die Bonddrähte 14 und 16 kann über eine Zuleitung 252 mit dem HF-Chip 12 verbunden sein. Alternativ kann auch der Bonddraht 14 direkt mit dem HF-Chip 12 verbunden sein.

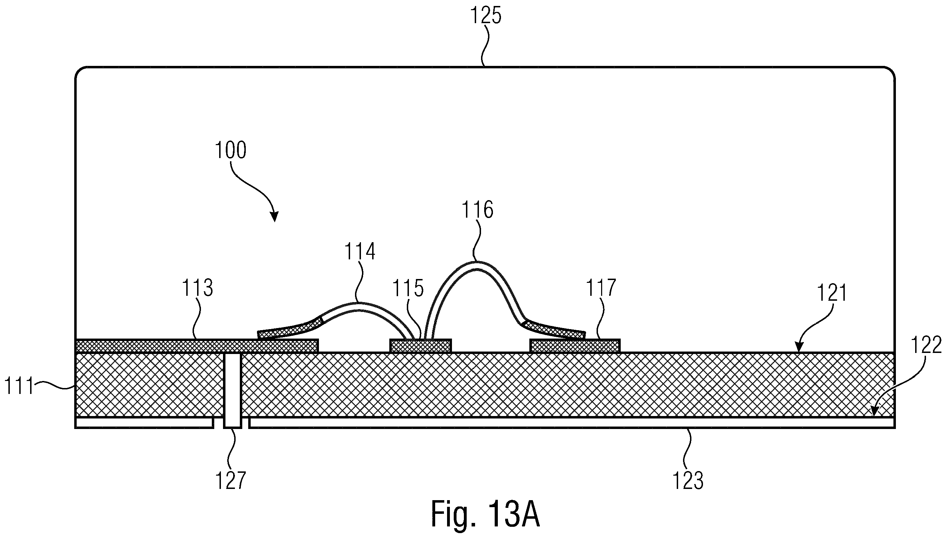

Wie es anhand der Figur 13A dargestellt ist, kann eine hierin beschriebene Antennenvorrichtung oder ein hierin beschriebenes Antennenarray ein Gehäuse 125 umfassen. Obwohl die Antennenvorrichtung 100 dargestellt ist, kann alternativ oder zusätzlich eine beliebige andere Antennenvorrichtung gemäß Ausführungsformen, ein beliebiges Antennenarray gemäß Ausführungsformen und/oder eine Kombination hiervon innerhalb des Gehäuses 125 angeordnet sein. Das Gehäuse 125 ist zumindest bereichsweise umfassend ein dielektrisches oder elektrisch isolierendes Material gebildet, um einen Austritt des Funksignals aus dem Gehäuse 125 zu ermöglichen. Beispielsweise kann das Gehäuse 125 ein Kunststoffmaterial oder ein Glasmaterial umfassen. Kunststoffmaterial kann während einer Vereinzelung und Verkapselung der Antennenvorrichtung 100 aus einem Wafer heraus angeordnet werden. Ein Innenvolumen des Gehäuses 125 kann zumindest teilweise mit einem Gas, wie etwa Luft oder einem Material mit einer geringen Dielektrizitätskonstante oder zu einem geringen Leistungsverlust führendem Material gefüllt sein. Die Metallisierung 123 kann mit einer Wand des Gehäuses 125 verbunden sein oder die Wand bilden, um eine Kontaktierung der Metallisierung mit anderen Komponenten auf einfachem Wege zu ermöglichen. Ferner kann das Gehäuse 125 einen Anschluss 127 aufweisen, der mit einer elektrisch leitfähigen Struktur verbunden ist, die bspw. als Via ausgeführt ist, um eine Anregung der Antennenvorrichtung 100 zu ermöglichen. Der Anschluss 127 kann zum Bereitstellen einer vertikalen Verbindung zu der Antennenvorrichtung 100 dienen, etwa an dem Befestigungsbereich 113 und/oder durch eine Verbindung zu einem HF-Chip, um die Antennenvorrichtung 100 anzuregen. Somit kann der Anschluss 127 einen Kontakt zur Umgebung der Antennenvorrichtung 100 bereitstellen.

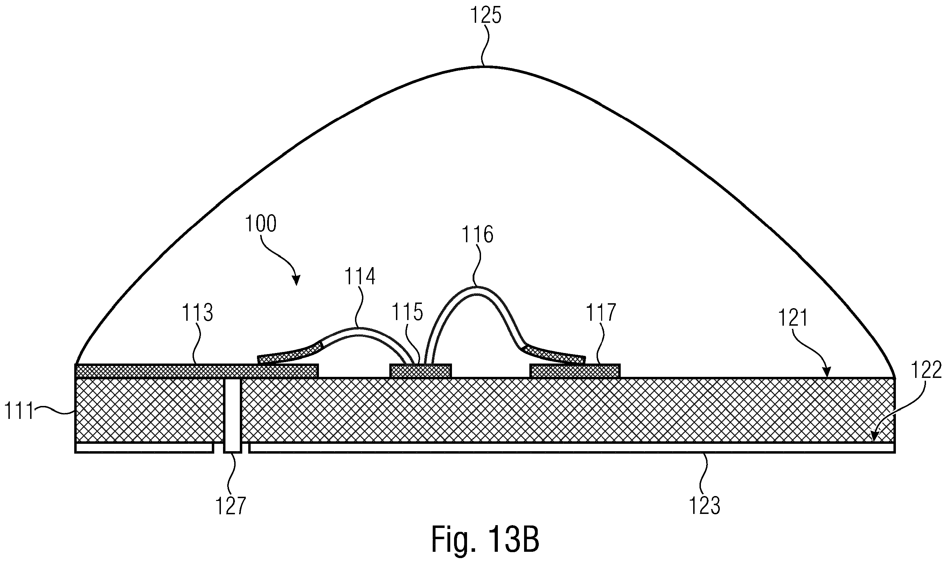

Fig. 13B zeigt eine schematische Seitenschnittansicht der Antennenvorrichtung 100 gemäß einem weiteren Beispiel, bei der das Gehäuse 125 im Vergleich zu Fig. 13A als Linse ausgeführt ist, die ausgebildet ist, um eine Abstrahlcharakteristik des Funksignals, welches mit der Antennenvorrichtung erzeugbar ist, zu beeinflussen. Bspw. kann die Linse ausgebildet sein, um das Funksignal zu bündeln. Bspw. kann das Innere des Gehäuses 125 zumindest teilweise mit einem dielektrischen Material gefüllt sein und eine äußere Form des Gehäuses 125 eine konkave oder konvexe Form aufweisen, um eine streuende oder bündelnde Funktion der Linse zu erhalten. Das bedeutet, dass das Gehäuse 125 eine Linse bilden kann, die ausgebildet ist, um ein von der Antennenvorrichtung erzeugtes Funksignal zu bündeln oder zu streuen.

Nachfolgend soll die Erfindung nochmals in anderen Worten zusammengefasst werden.

Bei höheren Frequenzen (z.B. im Millimeterwellenlängenbereich und größer) weisen bekannte Planarantennen, wie z.B. Patchantennen, Dipole, Monopole, usw. teils starke Verluste auf, die mit dem Dielektrikum in Zusammenhang stehen, welches zum Herstellen der Antenne benutzt wird. Beispiele hierfür sind dielektrische Verluste und Oberflächenwellenverluste.

Außerdem kann bei solch hohen Frequenzen die Verbindung zwischen dem RF-Chip und einer Antenne auf einem Interposer oder Board zu Signalintegritätsproblemen führen, die die Systemperformance schwächen.

Um diesen Problemen zu begegnen werden Bonddrahtantennen vorgeschlagen. Sie dienen als Verbindung zum Anschließen des RF-Chips und gleichzeitig als Antenne. Sie lösen die Herausforderungen, die mit dielektrischen Verlusten konventioneller Planarantennen verbunden sind und sie beseitigen die Notwendigkeit einer zusätzlichen Antenne auf dem Interposer oder dem Board.

Um bei hohen Frequenzen, z.B. bei Anwendungen im Millimeterwellenlängenbereich und darüber, der damit verbundenen hohen Freiraumdämpfung zu begegnen werden geeignete Antennenstrukturen (z.B. Arrays) benötigt.

Die bisher bekannten Bonddrahtantennen erlauben aufgrund ihres bisherigen Aufbaus jedoch nicht die direkte Verbindung eines Arrays mit dem Chip oder dem Chipträger.

Die vorliegende Erfindung hingegen schlägt Bonddrahtantennen vor, die all die genannten Probleme lösen. Die erfindungsgemäße Bonddrahtantenne weist mindestens zwei Drähte auf, die in einer Reihenschaltung zusammengebondet sind. Der erste Draht verbindet das Antennenpad auf dem Chip mit dem Interposer oder dem Chipträger. Der zweite Draht verlängert dann die elektrische Länge der erfindungsgemäßen Bonddrahtantenne auf dem Interposer oder dem Chipträger, wie z.B. in Figur 12A gezeigt.

Diese einfache Ausgestaltung einer Mehrdraht-Bonddrahtantenne kann beispielsweise genutzt werden, um eine Vielzahl unterschiedlicher Bonddrahtantennenkonfigurationen bereitzustellen. Beim Design von Mehrdraht-Bonddrahtantennen ist zu beachten, dass die Resonanzlänge durch die Länge beider Drähte und dem kurzen Verbindungspfad zwischen den Drahtspitzen der beiden Drähte bestimmt wird.

Die erfindungsgemäße Antennenvorrichtung kann beispielsweise mittels einer planaren Speiseleitung (z.B. Mikrostrip, Coplanar), elektromagnetischer Kopplung (z.B. Aperture- oder Proximity-Feed), oder einer vertikalen Sondenspeisung, z.B. mittels einer Durchkontaktierung, gespeist werden.

## Patentansprüche

1. Antennenvorrichtung (100) aufweisend
ein Substrat (111), das eine erste Hauptseite (121) und eine gegenüberliegend angeordnete zweite Hauptseite (122) aufweist;
einen ersten, einen zweiten und einen dritten an der ersten Hauptseite (121) angeordneten Befestigungsbereich (113, 115, 117) zum Befestigen von elektrischen Leitern;
zumindest einen den ersten Befestigungsbereich (113) und den zweiten Befestigungsbereich (115) verbindenden ersten Bonddraht (114), der zumindest bereichsweise von dem Substrat (111) beabstandet ist;
zumindest einen den zweiten Befestigungsbereich (115) und den dritten Befestigungsbereich (117) verbindenden zweiten Bonddraht (116), der zumindest bereichsweise von dem Substrat (111) beabstandet ist;
wobei der erste Bonddraht (114) mit einem Hochfrequenz-Chip verbindbar ist, und wobei die beiden elektrisch in Reihe geschalteten ersten und zweiten Bonddrähte (114, 116) eine Antenne bilden;
**dadurch gekennzeichnet, dass**
eine an der zweiten Hauptseite (122) des Substrats (111) angeordnete Metallisierung (123), die gegenüberliegend von zumindest einem des ersten Befestigungsbereichs (113), des zweiten Befestigungsbereichs (115), des dritten Befestigungsbereichs (117), des ersten Bonddrahts (114) und des zweiten Bonddrahts (116) angeordnet ist,
wobei der auf der ersten Hauptseite (121) des Substrats (111) angeordnete dritte Befestigungsbereich (117) und die an der zweiten Hauptseite (122) des Substrats (111) angeordnete Metallisierung (123) mittels einer elektrisch leitfähigen Struktur (124), die sich durch das Substrat (111) hindurch erstreckt, verbunden sind.

2. Antennenvorrichtung (100) nach Anspruch 1, wobei der erste, der zweite und der dritte Befestigungsbereich (113; 115; 117) in derselben Substratebene (150) liegen und der dritte Befestigungsbereich (117) in dieser Ebene (150) den ersten Befestigungsbereich (113) und/oder den zweiten Befestigungsbereich (115) zumindest abschnittsweise umgibt, sodass der dritte Befestigungsbereich (117) bezüglich des zweiten Befestigungsbereichs (115) und/oder bezüglich des ersten Befestigungsbereichs (113) eine komplanare Versorgungsleitung ausbildet.

3. Antennenvorrichtung (100) gemäß einem der vorhergehenden Ansprüche, wobei ein Wellenlängenbereich des von der Antenne gesendeten Funksignals von einer Summe der Länge des ersten Bonddrahts (114), der Länge des zweiten Bonddrahts (116) und einem Abstand (a₁₂) zwischen dem ersten und dem zweiten Bonddraht (114; 116) auf dem zweiten Befestigungsbereich (115) beeinflusst ist.

4. Antennenvorrichtung (100) nach Anspruch 3, wobei die Längen des ersten Bonddrahts (114) und des zweiten Bonddrahts (116) gemeinsam mit dem Abstand (a₁₂) zwischen dem ersten Bonddraht (114) und dem zweiten Bonddraht (116) auf dem zweiten Befestigungsbereich (115) derart gewählt sind, dass der Wellenlängenbereich des auszusenden Funksignals im Mikrowellenbereich, Millimeterbereich oder Terahertzbereich liegt.

5. Antennenvorrichtung (100) gemäß einem der vorangehenden Ansprüche, bei der der erste Befestigungsbereich (113) als eine Streifenleitung ausgeführt ist, wobei ein Wellenlängenbereich eines mittels des ersten Bonddrahts (114), des zweiten Bonddrahts (116) und der Streifenleitung (113) ausgesendeten Funksignals von einer Summe der einzelnen Längen des ersten Bonddrahts (114) und des zweiten Bonddrahts (116) und der Streifenleitung (113) beeinflusst ist.

6. Antennenvorrichtung (100) nach einem der vorhergehenden Ansprüche, wobei die Länge des ersten Bonddrahts (114) kürzer ist als die Länge des zweiten Bonddrahts (116).

7. Antennenvorrichtung (100) gemäß einem der vorangehenden Ansprüche, bei der der zweite Befestigungsbereich (115) und der dritte Befestigungsbereich (117) auf dem Substrat (111) angeordnete Bondpads sind, die räumlich voneinander beabstandet und galvanisch voneinander getrennt sind.

8. Antennenvorrichtung (100) gemäß einem der vorhergehenden Ansprüche, bei der die Metallisierung (123) Unterbrechungen aufweist.

9. Antennenvorrichtung (100) gemäß einem der vorhergehenden Ansprüche, bei der die an der zweiten Hauptseite (122) des Substrats (111) angeordnete Metallisierung (123) ein Reflektor für ein mittels des ersten Bonddrahts (114) und des zweiten Bonddrahts (116) ausgesendetes Funksignal ist.

10. Antennenvorrichtung (100) gemäß einem der vorhergehenden Ansprüche, wobei ein Wellenlängenbereich eines ausgesendeten Funksignals durch die Summe der einzelnen Längen des ersten und des zweiten Bonddrahts (114; 116) und der sich durch das Substrat (111) hindurch erstreckenden elektrisch leitfähigen Struktur (124) beeinflusst ist.

11. Antennenvorrichtung (100) gemäß einem der vorhergehenden Ansprüche, ferner umfassend ein Gehäuse (125), in dem die Antennenvorrichtung angeordnet ist, und das einen Anschluss (127) zum Verbinden der Antennenvorrichtung (100) mit einem Hochfrequenz-Chip (12) aufweist.

12. Antennenvorrichtung (100) gemäß Anspruch 11, bei der das Gehäuse (125) eine Linse bildet, die ausgebildet ist, um ein von der Antennenvorrichtung (100) erzeugtes Funksignal zu bündeln oder zu streuen.

13. Antennenarray (200) mit zumindest einer Antennenvorrichtung (100) gemäß der vorhergehenden Ansprüche, das zumindest einen dritten Bonddraht (118) aufweist, der einen auf der ersten Hauptseite (121) des Substrats (111) angeordneten vierten und fünften Befestigungsbereich (119, 120) miteinander verbindet, und das ferner zumindest einen vierten Bonddraht (214) aufweist, der einen auf der ersten Hauptseite (121) des Substrats (111) angeordneten sechsten und siebten Befestigungsbereich (206, 207) miteinander verbindet.

14. Antennenarray (200) gemäß Anspruch 13, bei der die Antennenvorrichtung (100) räumlich und galvanisch von dem vierten Befestigungsbereich (119), dem fünften Befestigungsbereich (120), dem sechsten Befestigungsbereich (206), dem siebten Befestigungsbereich (207), dem dritten Bonddraht (118) und dem vierten Drahtbond (214) getrennt ist, und wobei die Antennenvorrichtung (100), der dritte Bonddraht (118) und der vierten Bonddraht (214) so zueinander angeordnet sind, dass der dritte Bonddraht (118) bezüglich der Antennenvorrichtung (100) als ein Reflektor wirkt und der vierte Bonddraht (214) wirkt als ein Reflektor wirkt.

15. Antennenarray (200) gemäß einem der Ansprüche 13 oder 14, ferner umfassend ein Gehäuse (125), in dem die Antennenvorrichtung (100) angeordnet ist, und das einen Anschluss (127) zum Verbinden der Antennenvorrichtung (100) mit einem Hochfrequenz-Chip (12) aufweist.

16. Antennenarray (200) gemäß Anspruch 15, bei der das Gehäuse (125) eine Linse bildet, die ausgebildet ist, um ein von der Antennenvorrichtung (100) erzeugtes Funksignal zu bündeln oder zu streuen.

## Claims

1. An antenna apparatus (100) comprising:
a substrate (111) comprising a first main side (121) and a second main side (122) arranged opposite thereto;
first, second and third fixing regions (113, 115, 117) for fixing electric conductors which is arranged at the first main side (121);
at least one first bond wire (114) which connects the first fixing region (113) and the second fixing region (115) and is spaced apart from the substrate (111) at least in regions;
at least one second bond wire (116) which connects the second fixing region (115) and the third fixing region (117) and is spaced apart from the substrate (111) at least in regions;
wherein the first bond wire (114) may be connected to a high-frequency chip and wherein the first and second bond wires (114, 116) connected in series form an antenna;
**characterized in that**
a metallization (123) which arranged at the second main side (122) of the substrate (111) and is arranged opposite to at least one of the first fixing region (113), the second fixing region (115), the third fixing region (117), the first bond wire (114), and the second bond wire (116);
wherein the third fixing region (117) arranged at the first main side (121) of the substrate (111) and the metallization (123) arranged at the second main side (122) of the substrate (111) are connected by means of a conductive structure (124) extending through the substrate (111).

2. The antenna apparatus (100) according to claim 1, wherein the first, second and third fixing regions (113; 115; 117) are located within the same substrate plane (150), and the third fixing region (117) surrounds, within this plane (150), the first fixing region (113) and/or the second fixing region (115) at least in portions so that the third fixing region (117) configures a coplanar supply line with respect to the second fixing region (115) and/or with respect to the first fixing region (113).

3. The antenna apparatus (100) according to any of the previous claims, wherein a wavelength range of the radio signal sent by the antenna is influenced by a sum of the length of the first bond wire (114), of the length of the second bond wire (116), and of a distance (a₁₂) between the first and second bond wires (114; 116) on the second fixing region (115).

4. The antenna apparatus (100) according to claim 3, wherein the lengths of the first bond wire (114) and of the second bond wire (116) are selected together with the distance (a₁₂) between the first bond wire (114) and the second bond wire (116) on the second fixing region (115) such that the wavelength range of the radio signal to be emitted is within the microwave range, the millimeter range, or the terahertz range.

5. The antenna apparatus (100) according to any of the previous claims, wherein the first fixing region (113) is implemented as a strip line, wherein a wavelength range of a radio signal emitted by means of the first bond wire (114), the second bond wire (116), and the strip line (113) is influenced by a sum of the individual lengths of the first bond wire (114) and of the second bond wire (116) and of the strip line.

6. The antenna apparatus (100) according to any of the previous claims, wherein the length of the first bond wire (114) is shorter than the length of the second bond wire (116).

7. The antenna apparatus (100) according to any of the previous claims, wherein the second fixing region (115) and the third fixing region (117) are bond pads which are arranged on the substrate (111) and are spatially spaced apart from each other and galvanically separated from each other.

8. The antenna apparatus (100) according to any of the previous claims, wherein the metallization (123) comprises discontinuations.

9. The antenna apparatus (100) according to any of the previous claims, wherein the metallization (123) arranged at the second main side (122) of the substrate (111) is a reflector for a radio signal emitted by means of the first bond wire (114) and the second bond wire (116).

10. The antenna apparatus (100) according to any of the previous claims, wherein a wavelength range of an emitted radio signal is influenced by the sum of the individual lengths of the first and second bond wires (114; 116) and of the electrically conductive structure (124) extending through the substrate (111).

11. The antenna apparatus (100) according to any of the previous claims, further comprising a housing (125) in which the antenna apparatus is arranged and which comprises a terminal (127) for connecting the antenna apparatus (100) to a radio-frequency chip (12).

12. The antenna apparatus (100) according to claim 11, wherein the housing (125) forms a lens configured to concentrate or to diffuse a radio signal generated by the antenna apparatus (100).

13. An antenna array (200) comprising at least one antenna apparatus (100) according to any of the previous claims and comprising at least one third bond wire (118) connecting fourth and fifth fixing regions (119, 120) arranged on the first main side (121) of the substrate (111), and further comprising at least one fourth bond wire (214) connecting sixth and seventh fixing regions (206, 207) arranged on the first main side (121) of the substrate (111).

14. The antenna array (200) according to claim 13, wherein the antenna apparatus (100) is spatially and galvanically separated from the fourth fixing region (119), the fifth fixing region (120), the sixth fixing region (206), the seventh fixing region (207), the third bond wire (118) and the fourth wire bond (214), and wherein the antenna apparatus (100), the third bond wire (118), and the fourth bond wire (214) are arranged with respect to one another such that the third bond wire (118) acts as a reflector with respect to the antenna apparatus (100) and that the fourth bond wire (214) acts as a reflector.

15. The antenna array (200) according to any of claims 13 or 14, further comprising a housing (125) in which the antenna apparatus (100) is arranged and which comprises a terminal (127) for connecting the antenna apparatus (100) to a radio-frequency chip (12).

16. The antenna array (200) according to claim 15, wherein the housing (125) forms a lens configured to concentrate or to diffuse a radio signal generated by the antenna apparatus (100).

## Revendications

1. Dispositif d'antenne (100) présentant
un substrat (111) qui présente une première face principale (121) et une deuxième face principale (122) disposée du côté opposé;
une première, une deuxième et une troisième zone de fixation (113, 115, 117) disposées à la première face principale (121), destinées à fixer des conducteurs électriques;
au moins un premier fil de liaison (114) reliant la première zone de fixation (113) et la deuxième zone de fixation (115), qui est distant du substrat (111) au moins dans certaines zones;
au moins un deuxième fil de liaison (116) reliant la deuxième zone de fixation (115) et la troisième zone de fixation (117), qui est distant du substrat (111) au moins dans certaines zones;
dans lequel le premier fil de liaison (114) peut être connecté à une puce de haute fréquence, et dans lequel les deux premier et deuxième fils de liaison (114, 116) connectés électriquement en série forment une antenne;
**caractérisé par le fait que**
une métallisation (123) qui est disposée à la deuxième face principale (122) du substrat (111) et est disposée en face d'au moins l'un parmi la première zone de fixation (113), la deuxième zone de fixation (115), la troisième zone de fixation (117), le premier fil de liaison (114) et le deuxième fil de liaison (116),
dans lequel la troisième zone de fixation (117) disposée à la première face principale (121) du substrat (111) et la métallisation (123) disposée à la deuxième face principale (122) du substrat (111) sont connectées au moyen d'une structure (124) électriquement conductrice qui s'étend à travers le substrat (111).

2. Dispositif d'antenne (100) selon la revendication 1, dans lequel la première, la deuxième et la troisième zone de fixation (113; 115; 117) se trouvent dans le même plan de substrat (150) et la troisième zone de fixation (117) dans ce plan (150) entoure la première zone de fixation (113) et/ou la deuxième zone de fixation (115) au moins dans certains segments, de sorte que la troisième zone de fixation (117) constitue, par rapport à la deuxième zone de fixation (115) et/ ou par rapport à la première zone de fixation (113), une ligne d'alimentation coplanaire.

3. Dispositif d'antenne (100) selon l'une des revendications précédentes, dans lequel une plage de longueurs d'onde du signal radio émis par l'antenne est influencée par une somme de la longueur du premier fil de liaison (114), de la longueur du deuxième fil de liaison (116) et d'une distance (a₁₂) entre le premier et le deuxième fil de liaison (114; 116) sur la deuxième zone de fixation (115).

4. Dispositif d'antenne (100) selon la revendication 3, dans lequel les longueurs du premier fil de liaison (114) et du deuxième fil de liaison (116) sont sélectionnées, conjointement avec la distance (a₁₂) entre le premier fil de liaison (114) et le deuxième fil de liaison (116) sur la deuxième zone de fixation (115), de sorte que la plage de longueurs d'onde du signal radio à transmettre se situe dans la plage des micro-ondes, la plage millimétrique ou la plage térahertzienne.

5. Dispositif d'antenne (100) selon l'une des revendications précédentes, dans lequel la première zone de fixation (113) est réalisée en forme de ligne en ruban, dans lequel une plage de longueurs d'onde d'un signal radio transmis au moyen du premier fil de liaison (114), du deuxième fil de liaison (116) et de la ligne en ruban (113) est influencée par une somme des longueurs individuelles du premier fil de liaison (114) et du deuxième fil de liaison (116) et de la ligne en ruban (113).

6. Dispositif d'antenne (100) selon l'une des revendications précédentes, dans lequel la longueur du premier fil de liaison (114) est plus courte que la longueur du deuxième fil de liaison (116).

7. Dispositif d'antenne (100) selon l'une des revendications précédentes, dans lequel la deuxième zone de fixation (115) et la troisième zone de fixation (117) sont des plots de connexion disposés sur le substrat (111) qui sont spatialement distants l'un de l'autre et séparés de manière galvanique l'un de l'autre.

8. Dispositif d'antenne (100) selon l'une des revendications précédentes, dans lequel la métallisation (123) présente des interruptions.

9. Dispositif d'antenne (100) selon l'une des revendications précédentes, dans lequel la métallisation (123) disposée à la deuxième face principale (122) du substrat (111) est un réflecteur pour un signal radio émis au moyen du premier fil de liaison (114) et du deuxième fil de liaison (116).

10. Dispositif d'antenne (100) selon l'une des revendications précédentes, dans lequel une plage de longueurs d'onde d'un signal radio émis est influencée par la somme des longueurs individuelles du premier et du deuxième fil de liaison (114; 116) et par la structure (124) électriquement conductrice s'étendant à travers le substrat (111).

11. Dispositif d'antenne (100) selon l'une des revendications précédentes, comportant par ailleurs un boîtier (125) dans lequel est disposé le dispositif d'antenne et qui présente un raccordement (127) destiné à connecter le dispositif d'antenne (100) à une puce de haute fréquence (12).

12. Dispositif d'antenne (100) selon la revendication 11, dans lequel le boîtier (125) forme une lentille qui est conçue pour concentrer ou diffuser un signal radio généré par le dispositif d'antenne (100).

13. Réseau d'antennes (200) avec au moins un dispositif d'antenne (100) selon les revendications précédentes, le réseau d'antennes (200) présentant au moins un troisième fil de liaison (118) qui connecte l'une à l'autre une quatrième et une cinquième zone de fixation (119, 120) disposées sur la première face principale (121) du substrat (111), et présentant par ailleurs au moins un quatrième fil de liaison (214) qui connecte l'une à l'autre une sixième et une septième zone de fixation (206, 207) disposées sur la première face principale (121) du substrat (111).

14. Réseau d'antennes (200) selon la revendication 13, dans lequel le dispositif d'antenne (100) est séparé de manière spatiale et galvanique de la quatrième zone de fixation (119), de la cinquième zone de fixation (120), de la sixième zone de fixation (206), de la septième zone de fixation (207), du troisième fil de liaison (118) et du quatrième fil de liaison (214), et dans lequel le dispositif d'antenne (100), le troisième fil de liaison (118) et le quatrième liaison de fil (214) sont disposés l'un par rapport à l'autre de sorte que le troisième fil de liaison (118) agisse par rapport au dispositif d'antenne (100) comme un réflecteur et que le quatrième fil de liaison (214) agisse comme un réflecteur.

15. Réseau d'antennes (200) selon l'une des revendications 13 ou 14,comportant par ailleurs un boîtier (125) dans lequel est disposé le dispositif d'antenne (100) et qui présente un raccordement (127) destiné à connecter le dispositif d'antenne (100) à une puce de haute fréquence (12).

16. Réseau d'antennes (200) selon la revendication 15, dans lequel le boîtier (125) forme une lentille qui est conçue pour concentrer ou diffuser un signal radio généré par le dispositif d'antenne (100).
